# EUROPÄISCHE PATENTSCHRIFT

(11) **EP 2 010 691 B1**
(45) Veröffentlichungstag und Bekanntmachung des Hinweises auf die Patenterteilung: **06.12.2017**
(21) Anmeldenummer: 07724445.7
(22) Anmeldetag: 20.04.2007
(51) Int. Cl.: C23C 14/35, C23C 14/06, C23C 14/08, C23C 28/04, C23C 28/00, C23C 30/00, H01J 37/34

(54) **BESCHICHTETER KÖRPER**
COATED BODY
CORPS À REVÊTEMENT

(30) Priorität: 21.04.2006 DE 102006019055
(43) Veröffentlichungstag der Anmeldung: 07.01.2009
(73) Patentinhaber: CemeCon AG, 52146 Würselen (DE)
(72) Erfinder: CREMER, Rainer, 52156 Monschau (DE)
(74) Vertreter: Kalkoff & Partner
(86) Internationale Anmeldenummer: PCT/EP2007/003509
(87) Internationale Veröffentlichungsnummer: WO 2007/121954

(56) Entgegenhaltungen:
- EP-A2- 1 422 311
- WO-A-99/29920
- WO-A-03/085152
- DE-A1- 10 360 482
- JP-A- 2002 239 810
- YAMAMOTO ET AL: "Structural and mechanical property of Si incorporated (Ti,Cr,Al)N coatings deposited by arc ion plating process" SURFACE AND COATINGS TECHNOLOGY, ELSEVIER, AMSTERDAM, NL, Bd. 200, Nr. 5-6, 21. November 2005 (2005-11-21), Seiten 1383-1390, XP005173157 ISSN: 0257-8972
- WANG D -Y ET AL: "Improvement of the interfacial integrity of (Ti,Al)N hard coatings deposited on high speed steel cutting tools" SURFACE AND COATINGS TECHNOLOGY ELSEVIER SWITZERLAND, Bd. 120-121, November 1999 (1999-11), Seiten 388-394, XP002444203 ISSN: 0257-8972
- KARVANKOVA P ET AL: "Thermal stability of Cr1-xAlxSiyN coatings with medium to high aluminium content prepared by arc evaporation" SURFACE ENGINEERING FOR MANUFACTURING APPLICATIONS. SYMPOSIUM (MATERIALS RESEARCH SOCIETY SYMPOSIUM 28.11. - 01.12.2005, BOSTON, [US], MATERIALS RESEARCH SOCIETY SYMPOSIUM PROCEEDINGS, Bd. 890, 2006, Seiten 85-90, XP009087288 WARRENDALE, PA, [US] ISBN: 1-55899-844-6
- ROEDER P L ET AL: "The System Al2O3-Cr2O3-SiO2" JOURNAL OF THE AMERICAN CERAMIC SOCIETY, Bd. 51, Nr. 10, 21. Oktober 1968 (1968-10-21), Seiten 585-594, XP009087259 [US]
- DERFLINGER ET AL: "Mechanical and structural properties of various alloyed TiAlN-based hard coatings" SURFACE AND COATINGS TECHNOLOGY, ELSEVIER, AMSTERDAM, NL, Bd. 200, Nr. 16-17, 28. Februar 2006 (2006-02-28), Seiten 4693-4700, XP005336223 ISSN: 0257-8972
- HIRAI M ET AL: "Oxidation behavior of Cr-Al-N-O thin films prepared by pulsed laser deposition" PREPARATION AND CHARACTERIZATION, ELSEVIER SEQUOIA, NL, Bd. 407, Nr. 1-2, 22. März 2002 (2002-03-22), Seiten 122-125, XP004352908 ISSN: 0040-6090

## Beschreibung

Die Erfindung betrifft ein Schneidwerkzeug zum Zerspanen mit einem Substrat und einer auf dem Substrat aufgebrachten Hartstoffschicht sowie ein Verfahren zur Herstellung einer Hartstoffschicht.

Zur Verbesserung der Eigenschaften ist es bekannt, die Oberfläche von Körpern zu beschichten. Beschichtete Körper umfassen ein Substratmaterial und eine oder mehrere darauf aufgebrachte Schichten. Insbesondere für Werkzeuge, beispielsweise Bohrer, Fräser oder Wendeschneidplatten ist es bekannt, auf einem Substrat-Material, beispielsweise HSSStahl oder Hartmetall, eine oder mehrere Schichten aufzubringen.

Es sind verschiedene Materialien bzw. Materialsysteme aus verschiedenen Elementen bekannt, aus denen Hartstoffschichten gebildet werden können. Diese Schichten dienen besonders der Verbesserung der Härte, Warmhärte, Verschleissfestigkeit, Reibeigenschaften, der chemischen Beständigkeit und der Oxidationsbeständigkeit.

Besonders in Hinblick auf die Oxidationsbeständigkeit haben sich Schichten aus Aluminiumoxid bewährt. Diese werden häufig mit der CVD-Technik aufgebracht. Beispielsweise in US-A-4180400 ist die Abscheidung von kristallinem alphaAI₂O₃ mittels thermischem CVD beschrieben. Die CVD-Technik verwendet allerdings hohe Temperaturen, was zu einer entsprechenden Belastung der Substrate, und zu hohen Zugspannungen in der Schicht führt. Weiterer Nachteil ist u. A. die Verunreinigung mit Halogenen. Da Stahlwerkstoffe bei den hohen Temperaturen weich werden, werden CVDBeschichtungen für Werkzeuge und Verschleissteile vorwiegend auf Hartmetall aufgebracht. Doch selbst diese relativ temperaturbeständigen Substrate werden beim CVD durch eta-Phasenbildung in der Oberfläche versprödet. Überdies führen die hohen Temperaturen auf Grund der unterschiedlichen Wärmeausdehnung zu den bei CVD bekannten schädlichen hohen Zugspannungen. Die Schichten weisen deshalb in der Regel ein Rissnetzwerk auf, das den Schichtverbund schwächt und den Korrosionsschutz der Schicht verschlechtert.

Eine alternative Beschichtungstechnik sind insbesondere plasmagestützte PVD-Verfahren. Bekannt sind hier einerseits PVD-Verfahren mittels Lichtbogenverdampfens (Are-Verfahren), bei denen das metallische Element über die schmelzflüssige Phase verdampft wird und andererseits das Magnetronzerstäuben, bei dem Targets aus dem zu zerstäubenden Material als Kathode einer elektrischen Niederdruckglimmentladung eingesetzt werden, wobei Ionen des Plasmas die Targets zerstäuben.

Bei der Beschichtung mit Oxidschichten gibt es jedoch erhebliche Einschränkungen bei der verwendeten Beschichtungstechnik, da diese Schichten i.d.R. elektrisch isolierend sind.

Es fehlt nicht an Versuchen, kristalline Phasen des Aluminiumoxids mittels PVD aufzubringen. Dabei lässt sich bei den verwendeten niedrigen Temperaturen, wie beschrieben in US-A-4790920, US-A-5693417 und US-A-6210726, vor allem die kristalline gamma-Phase erzeugen.

In der EP-A-1614655 sind eine Hartstoffbeschichtung und ein PVD-Herstellungsverfahren hierfür beschrieben. Die Hartstoffbeschichtung wird mit Hilfe eines PVD-Verfahrens aufgebracht, bei dem einerseits das Material eines AIP-Targets (Arc discharge Ion Plating) mit Hilfe von Lichtbogenverdampfen und andererseits das Material eines MS-Targets (Magentron Sputtering) mit Magnetronzerstäben in ein Plasma überführt wird. Dabei werden Sauerstoff-haltige Prozessgase zugeführt. Die Schicht umfasst die Metall-Elemente Si und mindestens ein weiteres Element ausgewählt aus den Übergangsmetallen der Gruppen 4a, 4a und 6a des Periodensystems, Al und B. Weiter umfasst die Beschichtung nicht-metallische Elemente ausgewählt aus C, N und O. Sauerstoff wird zur Verbesserung der Schmierung eingesetzt, allerdings ist der Anteil des Sauerstoffs an den nicht-metallischen Elementen auf 5 At.-% beschränkt.

In der EP-A-701982 sind mehrlagige Schichten beschrieben. Gezeigt ist ein Verbund ultrafeiner Teichen aus Carbiden, Nitriden, Carbonitriden oder Oxiden mit Metallen der Gruppen 4-6 des Periodensystems (IUPAC 1988) sowie B, Al oder Si zusammensetzen, wobei jeweils wenigstens eine Schicht im kubischen und eine Schicht im nichtkubischen System oder amorph vorliegt. Die Schichten der erfindungsgemäßen Beispiele werden mittels Niedervoltbogenverdampfung aufgebracht. Das Schichtsystem muss mehr als zwei Schichten aufweisen.

In der EP-A1422311 werden Hartstoffschichten beschrieben, die mittels Lichtbogenverdampfens hergestellt werden. Die Schicht beinhaltet u. a. die metallischen Elemente Al, Cr, und Si sowie die nichtmetallischen Elemente N, B, C und O. Es sind zahlreiche Kombinationen mit den genannten Elementen genannt, jedoch geht der Sauerstoffanteil unter den nichtmetallischen Elementen nicht über 25 At. % hinaus.

In Yamamoto et al: "Structural and mechanical property of Si incorporated (Ti,Cr,Al)N coatings deposited by arc ion plating process" SURFACE AND COATINGS TECHNOLOGY, ELSEVIER, AMSTERDAM, NL, Bd. 200, Nr. 5 - 6, 21. November 2005 (2005-11-21), Seiten 1383 - 1390, XP005173157, ISSN: 0257-8972 werden (Ti, Cr, Al, Si)N-Beschichtungen auf WC-Co Wendeschneidplatten untersucht. Die Substrate werden zunächst einem Ätzverfahren mit Argonionen unterworfen und dann durch Lichtbogen-Ionenplattieren mit Hilfe einer plasmaunterstützten Kathode beschichtet. Erwähnte, hierbei erzielte Zusammensetzungen sind (Ti_{0.2}, Cr_{0.2}, Al_{0.55}, Si_{0.05}) N, (Ti_{0.15}, Cr_{0.2}, Al_{0.6}, Si_{0.05})N, (Ti_{0.2}, Cr_{0.23}, Al_{0.53}, Si_{0.04})N, (Ti_{0.14}, Cr_{0.22}, Al_{0.59}, Si_{0.05})N. In einer auf die Oxidationsbeständigkeit gerichteten Untersuchung werden beschichtete Substrate in Luft bei 1000°C für 30 Minuten wärmebehandelt, wobei es zur Oxidation kommt. In einem AES-Tiefenprofil variiert hierbei der atomare Anteil von Sauerstoff in der so behandelten Schicht zwischen 60 und 0 at.-%.

In der WO 99/29920 A ist ein Schneidwerkzeug beschrieben, das aus einem Substrat aus Hartmetall, Cermet, Keramik oder HSS-Stahl besteht und auf dessen Oberfläche mittels PVD oder CVD eine harte, abriebbeständige Hartstoffbeschichtung aufgebracht ist. Auf dem Substrat kann eine erste Schicht aus TiN, TiC, TiCN oder TiAlN aufgebracht sein. Die darüber aufgebrachte Hartstoffschicht einer Dicke von 0,5 bis 20, bevorzugt 2 bis 6 µm ist als Multilayer-Schicht ausgebildet im Wechsel aus Metallnitrid- oder Metallkarbid-Nanoschichten und Al₂O₃-Nanoschichten. Die Metallnitrid- oder Metallkarbid-Schichten enthalten zwei aus der Gruppe Ti, Nb, Hf, V, Ta, Mo, Zr, Cr, W, Al ausgewählte Metallelemente. Die Schichtdicke jeweils einer Al₂O₃- und Metallnitrid- oder Metallkarbid-Schicht beträgt zwischen 3 und 100 nm, bevorzugt weniger als 25 nm. Die Schicht wird bevorzugt im PVD-Verfahren mit bipolar gepulstem Magnetron-Sputtern aufgebracht, wobei die einzelnen Schichten durch An- und Abschalten separater Magnetron-Systeme erzeugt werden.

In Wang et al: "Improvement of the interfacial integrity of (Ti,Al)N hard coatings deposited on high speed steel cutting tools" SURFACE AND COATINGS TECHNOLOGY ELSEVIER SWITZERLAND, Bd. 120 - 121, November 1999 (1999-11), Seiten 388 - 394, SP002444203 ISSN: 0257-8972 wird eine (Ti, Al)N-Beschichtung auf HSS-Werkzeugen untersucht. Um Haftungsproblemen zu begegnen, die aufgrund der großen Diskrepanz der thermischen Eigenschaften auftreten, wird eine dünne TiN-Haftschicht von 0.2 µm aufgebracht.

In der DE 103 60 482 A1 ist ein mit einer Hartstoffschicht versehenes Substrat, beispielsweise Hartmetall, HSS-Stahl, Cermet oder dergleichen beschrieben. Die Beschichtung besteht aus mehreren Schichten, von denen die äußerste Schicht kubisches Bornitrid ist. Um eine gute Haftung auf dem Substrat zu erreichen, ist direkt auf dem Substrat eine Haftschicht aufgebracht, die aus einem oder mehreren Metallen ausgewählt aus der Gruppe bestehend aus den Elementen in den Gruppen 4a, 5a und 6a des Periodensystems oder ein Nitrid und/oder Karbonitrid eines oder mehrerer dieser Metalle umfaßt. Zwischen der Haftschicht und der Oberflächenschicht befindet sich eine Gradientenschicht, in der sich der Gehalt an B und C von der Haftschicht zur Oberflächenschicht hin kontinuierlich oder schrittweise ändert. Die beschriebenen Schichten werden in einem PVD-Verfahren mittels nicht ausgeglichenem Magnetron-Sputtern erzeugt, wobei ein Target die genannten Metalle und ein weiteres Target mindestens B und C enthält.

In der WO 03/085152 A2 ist ein Werkzeug beschrieben mit einem Substrat und einer oder mehrer darauf aufgebrachten Schichten aus einem Materialsystem, das Aluminium, Stickstoff und ein oder mehrere weitere Elemente umfasst, die die Eigenschaft haben, dass sie kubische Nitride in NaCl-Struktur ausbilden. Die Schicht hat eine geringe elektrische Leitfähigkeit. Insbesondere können die weiteren Elemente ausgewählt werden aus der Gruppe der Elemente An, Ce, Cr, Cm, Er, Eu, Gd, Hf, La, Lu, Mo, Mn, Mb, Nd, Np, Pa, Pr, Pu, Re, Sc, Sm, Sr, Ta, Tb, Tc, Th, Ti, U, V, W, Y, Yb, Zr.

Es ist Aufgabe der Erfindung, ein Werkzeug zum Zerspanen sowie ein Verfahren zur Herstellung eines beschichteten Körpers, vorzuschlagen, bei denen Schichten mit besonders günstigen Eigenschaften Verwendung finden.

Diese Aufgabe wird gelöst durch ein Schneidwerkzeug nach Anspruch 1 und ein Verfahren nach Anspruch 15. Abhängige Ansprüche beziehen sich auf bevorzugte Ausführungsformen der Erfindung.

Bei dem erfindungsgemäßen Schneidwerkzeug ist die Hartstoffschicht mittels Magnetronzerstäubens abgeschieden und enthält die metallischen Elemente Al, Cr und Si sowie nichtmetallische Elemente ausgewählt aus der Gruppe B, C, N, O. Der atomare Anteil von Sauerstoff an den nichtmetallischen Elementen ist größer als 30%.

Ein derartiger Körper hat besonders gute Oberflächeneigenschaften für die Verwendung als Schneidwerkzeug zum Zerspanen. Durch den hohen Sauerstoffanteil ergibt sich eine sehr gute Oxidationsbeständigkeit der Schicht. Ein zu geringer Sauerstoffanteil führt hingegen zu einer zu geringen Oxidationsbeständigkeit.

Neben Sauerstoff können in der Hartstoffschicht weitere nichtmetallische Elemente vorhanden sein, bevorzugt aus der Gruppe B, C, N. Bezüglich der nichtmetallischen Elemente in der Schicht werden in dieser Schrift die relativen atomaren Anteile der nichtmetallischen Elemente B,C,N,o untereinander angegeben und mit der Einheit Atomprozent oder At.% versehen. Die nichtmetallischen Elemente sind bevorzugt weit überwiegend (i. e. mehr als 80 At.%), bevorzugt zu nahezu 100 At.%, chemisch an die metallischen Elemente gebunden.

Bevorzugt ist der atomare Anteil von Sauerstoff an den nichtmetallischen Elementen größer als 70%.

Bei den At.% Angaben ist zu berücksichtigen, daß die Schichten stets z. B. durch den Herstellungsprozeß bedingte zusätzliche Elemente enthalten können, die als Verunreinigungen wirken. Bei PVD-Sputterschichten sind die Schichten in der Regel mit dem als Prozeßgas verwendeten Edelgas verunreinigt. Die Verunreinigung z. B. mit Argon liegt meist bei nicht mehr als 3 At.%. Ein typischer Wert ist 1-2 At.%. Das ggf. vorhandene Sputtergas Krypton wird nicht oder wesentlich schwächer eingebaut.

Dagegen sind die im PVD-Verfahren erzeugten Schichten im Gegensatz zu CVD-Schichten frei von Halogeniden und/oder Wasserstoff.

Die Verunreinigung durch Metalle ist beim Sputtern in der Regel gering, wenn die Kammer und die Haltersysteme schon mit dem Beschichtungsmaterial belegt sind und die Targets eine hohe Reinheit besitzen.

In einer besonders bevorzugten Ausführung beträgt der Sauerstoffgehalt der Hartstoffschicht nahezu 100% At.%, d.h. bis auf ggfs. vorhandene Verunreinigungen ist an nichtmetallischen Elementen ausschließlich Sauerstoff in der Schicht enthalten. Durch sehr hohe Sauerstoffgehalte ergibt sich eine hervorragende Oxidationsbeständigkeit.

In Fällen, in denen zwar eine erhöhte Oxidationsbeständigkeit, aber zusätzlich eine hohe Härte erzielt werden soll, können alternativ die nichtmetallischen Elemente auch so gewählt werden, dass neben einem hohen Sauerstoffanteil (30 At.% und mehr) ein Stickstoffanteil vorhanden ist. Wie sich herausgestellt hat, lassen sich besonders harte Schichten bis zu 3500 HV erzielen, wenn in der Hartstoffschicht im Wesentlichen (d.h. neben üblichen Verunreinigungen) als Nichtmetalle nur Sauerstoff und Stickstoff vorliegen, wobei der atomare Anteil von Stickstoff im Verhältnis zur Summe von Sauerstoff und Stickstoff größer gleich 10 At.% und kleiner gleich 70 At.% ist. Weiter bevorzugt ist der Stickstoffanteil größer gleich 30 At.%, besonders bevorzugt größer gleich 50 At.%. Die Hartstoffschichten können weitere Metalle, bevorzugt Elemente aus den Gruppen 4 bis 6 des Periodensystems (nach IUPAC 1988) enthalten. Die Beimengung anderer metallischer (und nichtmetallischer) Elemente sollte allerdings in der Menge begrenzt sein, da hierdurch Härte, Dichte, Schichthaftung, Schichtstruktur und Schichtspannungen ungünstig beeinflusst werden können. Metallische Elemente, die keine mechanisch stabilen Oxide ausbilden, sollten in der Schicht nur in beschränktem Maße vorhanden sein sollten. Denn durch die Verwendung von Sauerstoff als Reaktivgas entstehen Oxide dieser Elemente in der Schicht, die bei abrasiver Belastung die Erosion der Schicht fördern können. Beispielsweise sind Titanoxide den Schichteigenschaften in der beschriebenen Weise abträglich.

Durch geeignete Auswahl der Mengenverhältnisse der metallischen Elemente lassen sich die Eigenschaften günstig beeinflussen. Die Prozentangaben in Atomprozent (At.%) sind in dieser Schrift, wenn nicht anders gesagt, die relativen Anteile der metallischen Elemente Al, Cr und Si untereinander.

An metallischen Elementen enthält die Hartstoffschicht bevorzugt überwiegend (d.h. zu mehr als 50 At.%) Elemente der Gruppe Al, Cr, Si. Weiter bevorzugt ist der atomare Anteil der metallischen Elemente dieser Gruppe größer als 80 At.%. Besonders bevorzugt ist der Anteil nahezu 100 At.%, d.h. daß bis auf ggfs. vorhandene Verunreinigungen sind an metallischen Elementen ausschließlich Al, Cr und Si in der Schicht enthalten. Ein wesentlicher Grund für die Vorteile des erfindungsgemäßen Körpers ist, dass die Elemente Al, Cr, Si alle stabile Oxide und Nitride bilden. Wie noch beschrieben wird, können Nitride bevorzugt für Haft- oder Übergangsschichten verwendet werden um eine gute Substrathaftung zu erzielen.

Weitere Verbindungen und Oxide können zwar bspw. als Festschmierstoffe den Zerspanprozess verbessern. In der eigentlichen Hartstoffschicht ist ihr Anteil aber wie dargestellt zu begrenzen. Sie können bevorzugt als separate, obere Funktionsschichten oder als Zwischenschichten in einer Multilayer-Struktur vorgesehen sein.

Bevorzugt beinhaltet die Hartstoffschicht Oxide und/oder Mischoxide der Elemente Al, Si und Cr. In zahlreichen Versuchen hat sich herausgestellt, dass Hartstoffschichten, die eine Kombination aus Oxiden und/oder Mischoxiden der Elemente Al, Cr und Si enthalten besonders günstige Schichteigenschaften hinsichtlich Härte, Haftung, Zähigkeit und Oxidationsbeständigkeit aufweisen.

Gemäß einer Weiterbildung der Erfindung umfasst die Hartstoffschicht die metallischen Elemente Al, Cr und Si im Verhältnis (in At.% nur der metallischen Elemente) x zu y zu z. Bevorzugt ist eine Zusammensetzung mit einem Cr-Anteil y zwischen 1% und 70% und einem Si-Anteil z zwischen 0,1% und 20%, Rest Al. Weiter bevorzugt ist y zwischen 4% und 60%, z zwischen 0,5% und 10%, Rest Al. Besonders bevorzugt ist y zwischen 10% und 50%, z zwischen 1% und 5%, Rest Al. Außerhalb der beanspruchten Bereiche nehmen vor allem Härte und Haftung der Schichten ab, so dass keine Vorteile bei Verschleißanwendungen zu erwarten sind.

Die Hartstoffschicht kann einphasig sein, bspw. in der gamma-Phase des Al₂O₃ vorliegen. Alternativ kann die Hartstoffschicht mehrphasig sein. Die Hartstoffschicht kann sich bspw. zusammensetzen aus Al₂O₃ in der gamma-, alpha-, oder kappa-Phase, aus Cr₂O₃, SiO₂, sowie aus Substitutionsmischkristallen der Elemente Al-Cr-Si-O.

Bei Anwesenheit von Stickstoff liegen auch Phasen im System Al-Cr-Si-O-N vor, bspw. Si₃N₄, AlN, CrN und Cr2N. Diese können als amorphe Verbindungen vorliegen, insbesondere die Si-Verbindungen.

Bevorzugt sind in der Hartstoffschicht kristalline Phasen und/oder Mischphasen im System Al-Cr-Si-O enthalten, im Besonderen in der Zusammensetzung (Al,Cr,Si)₂O₃.

Es können sich sowohl kubische Phasen der Raumgruppe Fd3m als auch hexagonale Phasen der Raumgruppe R-3c ausbilden. Die hexagonalen Phasen bilden sich vor allem bei Cr-reichen Zusammensetzungen (bspw. über 50 At.% Cr). Die kubische Phase kann sich schon bei geringen Cr-Gehalten deutlich unter 5 At.% bilden. Zur kubischen Phase gehören auch Substitutionsmischkristalle des gamma-Al2O3, in denen Al durch andere Elemente ersetzt ist. Werden derartige Materialien mittels Röntgenbeugung untersucht, sind in den XRD-Spektren häufig nur Phasen des Systems (Al,Cr)2O3 zu erkennen. Offenbar fördert ein gewisser Si-Anteil die Bildung dieser Phasen, denn die Phasen treten nur auf, wenn auch Si in der Schicht enthalten ist. Andererseits sollte der Si-Anteil bevorzugt begrenzt bleiben, da es sonst zu einer Verminderung der Schichthaftung kommt.

Bei dem erfindungsgemäßen Verfahren wird die Schicht mittels Magnetronzerstäubens aufgebracht. Beim Magnetronzerstäuben erfolgt unmittelbar aus der festen Phase das Zerstäuben der Targets. Im Gegensatz hierzu wird bei PVD -Verfahren mittels Lichtbogenverdampfens (Arc-Verfahren) das metallische Element über die schmelzflüssige Phase verdampft. Das Magnetronzerstäuben vermeidet dabei die hieraus resultierenden Nachteile wie den Einbau von aufgeschmolzenen Kleinstpartikeln, sog. droplets. Vor allem aber hat sich bezüglich Arc-Verfahren herausgestellt, dass das Einbringen von Sauerstoff wegen einer sofortigen Reaktion des Sauerstoffs mit dem aufgeschmolzenen Material problematisch sein kann. Gleiches gilt für das thermische Aufschmelzen von Metallen aus Tiegeln oder mittels Elektronenstrahls.

Beim Magnetronzerstäuben, bei dem Targets aus dem zu zerstäubenden Material als Kathode einer elektrischen Niederdruckglimmentladung geschaltet sind, zerstäuben Ionen des Plasmas das Target, ohne dass die Schmelztemperatur des Targetmaterials erreicht werden muss. Zur Erhöhung der Plasmadichte und der Abtragsraten befindet sich hinter dem Target ein Magnetsystem.

Die Temperaturen können - auch bspw. durch Kühlung des Targets - niedrig gehalten werden. Hierdurch bleiben Reaktionen des Targetmaterials mir den Reaktivgasen gering. Deshalb ist das Magnetronverfahren besonders gut geeignet, auch Oxide, im besonderen Aluminiumoxid, bei niedrigen Temperaturen abzuscheiden. Die Temperaturen bleiben dabei bevorzugt unter 500°C.

Durch ein zusätzliches negatives Potential am Substrattisch kann das Substrat während der Beschichtung mit Ionen beschossen werden. Dies verbessert in der Regel die Qualität der Schichteigenschaften wie Dichte, Haftung, Härte, Porosität u.a. Durch den Ionenbeschuss wird ferner die Schichtbildung durch Reaktion mit dem vorhandenen Reaktivgas, im vorliegenden Fall bevorzugt Sauerstoff, gefördert.

Die Targets werden beim Magnetronzerstäuben nach kurzer Einfahrzeit gleichmäßig entsprechend ihren Materialanteilen abgetragen. Die Targets können aus Legierungen oder Verbindungen der Beschichtungsmaterialien bestehen. Ferner können die Targets aus unterschiedlichen Materialsegmenten zusammengesetzt sein. Bei Verwendung mehrerer Magnetrons können diese ferner mit unterschiedlichen Targetmaterialien bestückt werden. Im Prinzip können Beschichtungen mit allen Metallen und Metalloiden hergestellt werden.

Sollen die Temperaturen sehr niedrig gewählt werden und soll ein hoher Anteil an kristallinen Phasen in der Hartstoffschicht vorliegen, können Mittel zur Zusatzionisation, wie z.B. Hohlelektroden eingesetzt werden.

Für die Magnetronabscheidung von Oxiden kann man, statt herkömmliche Gleichstromplasmen zu verwenden, die Elektroden mit Wechselspannung betreiben. Die Druckschriften US-A-4046659 und US-A-4013532 sowie DD 252205 beschreiben Beschichtungsvorrichtungen und -verfahren, bei denen die Elektroden nicht mit Gleichspannung, sondern mit Wechselspannung betrieben werden (gepulste Plasmen).

Gemäß einer Weiterbildung der Erfindung wird das so genannte "hochleistungsgepulste Magnetronzerstäuben" (englisch "High Power Impuls Magnetron Sputtering" oder kurz HIPIMS) eingesetzt. Dieses ist gekennzeichnet durch kurze Pulse von sehr hoher Leistung. Die Pulse können so hohe Leistungen aufweisen, daß von den Targets eine Leistungsdichte von 500-5000 W/cm² erreicht werden, die aber nur für maximal 20% der Zykluszeit anliegen. Aufgrund des sehr niedrigen Tastverhältnisses (An-Zeit zu Aus-Zeit) liegt die Leistung im zeitlichen Mittel dann wieder im selben Bereich wie bei herkömmlichen DC- oder Puls-PVD Verfahren. Es ergibt sich aber eine nahezu vollständige Ionisation vor dem Target. Wie sich für die erfindungsgemäßen Schichten herausgestellt hat, werden durch HIPIMS besonders dichte und harte Schichten erzeugt.

Gemäß einer Weiterbildung der Erfindung ist zwischen dem Substrat, d.h. dem Material des Grundkörpers, und der Hartstoffschicht eine Haftschicht angeordnet. Hierdurch kann die Schichthaftung auf dem Substrat entscheidend verbessert werden. Die jeweilige Zusammensetzung und Dicke der Haftschicht sollte abhängig vom jeweiligen Substratmaterial gewählt werden. Hier spielen die chemische Bindung, die Ausdehnungskoeffizienten und Gitterparameter von Substrat und Schicht eine Rolle.

Die Haftschicht setzt sich bevorzugt aus einer Auswahl von Elementen aus der Menge Al, Si und Elementen der Gruppen 4 bis 6 des Periodensystems nach IUPAC (1988), sowie aus einer Auswahl von nichtmetallischen Elementen aus der Gruppe B, C, N, O zusammen. Bei den metallischen Anteilen der Haftschicht sind die Elemente Ti, Al, Si, Cr bevorzugt. In der Haftschicht ist der Sauerstoffanteil geringer als in der Hartstoffschicht. Die Haftschicht ist bevorzugt direkt auf dem Substratmaterial aufgetragen.

Bevorzugt sind die metallischen Elemente der Haftschicht aus der Gruppe der metallischen Elemente der Hartstoffschicht ausgewählt. Weiter bevorzugt ist in der Haftschicht ein atomarer Anteil von N an den nichtmetallischen Elementen vorhanden, der größer ist als in der Hartstoffschicht. Der Anteil an N ist besonders bevorzugt im Wesentlichen bei 100% At.%, d.h. dass es sich - bis auf Verunreinigungen - um eine reine Nitridschicht handelt.

Bevorzugt ist eine Kombination von Hartstoffschicht und Haftschicht, in der die Hartstoffschicht im Wesentlichen (d.h. bis auf Verunreinigungen an metallischen oder nichtmetallischen Elementen) aus Al, Cr, Si und O besteht und die Haftschicht im Wesentlichen aus Al, Cr, Si und N, insbesondere aus kristallinem (Al,Cr,Si)N. Alternativ kann die Haftschicht auch aus kristallinem (Ti, Al)N bestehen und die Hartstoffschicht aus AlCrSiO.

Die Hartstoffschicht kann zwar direkt auf die Haftschicht folgen. Gemäß einer Weiterbildung der Erfindung ist aber zwischen der Haftschicht und der Hartstoffschicht bevorzugt eine Übergangsschicht angeordnet. Diese setzt sich aus einer Auswahl der Elemente zusammen, die die Hartstoff- und Haftschicht bilden. So findet ein Übergang von der Zusammensetzung der Haftschicht zur Zusammensetzung Hartstoffschicht statt.

Es hat sich besonders bewährt, für Haft- und Übergangsschichten die gleiche Zusammensetzung an metallischen Elementen, wie in der Hartstoffschicht zu wählen und als nicht-metallisches Element vorwiegend N zu verwenden. Dies gilt besonders für Hartmetall-Substrate.

Bevorzugt ändert sich in der Übergangsschicht in der Richtung quer zur Schicht wenigstens ein Element in seiner Konzentration kontinuierlich, so dass die Konzentration des Elements an der Grenze zur Hartstoffschicht im wesentlichen gleich der Konzentration in der Hartstoffschicht ist und an der Grenze zur Haftschicht im wesentlichen gleich der Konzentration in der Haftschicht ist. Bei dem variierenden Element handelt es sich bevorzugt um N, O, oder um beide dieser Elemente.

Es ist eine Vielzahl von möglichen Schichtfolgen denkbar. Im einfachsten Fall besteht der Körper nur aus dem Substratmaterial mit einer in ihrer Zusammensetzung konstanten Hartstoffschicht. Bevorzugt sind wie oben beschrieben jeweils mindestens eine Haft- und Zwischenschicht zwischen Substrat und Hartstoffschicht. Da im Einsatz bei starkem Verschleiß der Hartstoffschicht auch Haft- und ggfs. Übergangsschicht teilweise freigelegt werden können, kommt es auch auch bei diesen Schichten auf die Eigenschaften zum Schutz des Substrates an. Die Dicke des gesamten Schichtsystems beträgt bspw. 1-10, bevorzugt 2-8, besonders bevorzugt 3-5 µm. Falls eine Haftschicht vorhanden ist, umfaßt diese bspw. 10 - 70 %, bevorzugt 25 - 60 %, besonders bevorzugt mindestens 35 % des Schichtsystems. Die Dicke der Übergangsschicht kann in derselben Größenordnung liegen wie die der Hartstoffschicht. Die Übergangsschicht ist aber bevorzugt dünner, und liegt weiter bevorzugt im Bereich von 2-200 nm.

Der Körper kann allerdings auch beispielsweise eine Mehrlagenbeschichtung (multilayer) aufweisen. Diese kann Schichten mit Zusammensetzungen wie vorstehend als Haft- und Übergangsschichten beschrieben im Wechsel mit den beschriebenen Hartstoffschichten umfassen. Ebenso ist eine Folge von Hartstoffschichten möglich, wobei sich die Zusammensetzung der metallischen Elemente im Wesentlichen periodisch ändert. Beispielsweise sind Mehrlagenbeschichtungen vorteilhaft, bei deren Herstellung die Reaktivgase N2 und O2 periodisch und gegenläufig variiert werden um entsprechende periodische Variationen im Schichtmaterial zu erzeugen. Andere Mehrlagenbeschichtungen ergeben sich, wenn Targets unterschiedlicher Zusammensetzung an- und abgeschaltet bzw. in der Leistung variiert werden. Mehrlagenbeschichtungen mit Einzelschichtdicken im Nanometerbereich ergeben sich, wenn die Substrate auf Drehtischen periodisch an Targets mit unterschiedlicher Zusammensetzung vorbeigeführt werden.

Nachfolgend werden Ausführungsformen der Erfindung in Hinblick auf die beigefügten Zeichnungen näher beschrieben. In den Zeichnungen zeigen
- Fig. 1: in symbolischer Darstellung ein Beispiel von Bestandteilen einer PVD-Beschichtungsanlage,
- Fig. 2: in symbolischer Darstellung ein erstes Ausführungsbeispiel eines beschichteten Körpers mit einer Haftschicht, einer Übergangsschicht und einer Hartstoffschicht,
- Fig. 3: in symbolischer Darstellung ein zweites Ausführungsbeispiel eines beschichteten Körpers mit einer Multilayer-Struktur,
- Fig. 4: eine Fotografie eines Schliffs einer ersten Ausführungsform einer (Al,Cr,Si)2O3-Hartstoffschicht,
- Fig. 5: eine Fotografie eines Schliffs einer zweiten Ausführungsform einer (Al,Cr,Si)2O3-Hartstoffschicht,
- Fig. 6: eine Fotografie eines Schliffs einer Al2O3 Hartstoffschicht auf einer (Al,Cr,Si)N Haftschicht als Vergleichsbeispiel,
- Fig. 7: in Diagrammform XRD-Spektren von Hartstoffschichten der Art Al-Cr-Si-O,
- Fig. 8: in Diagrammform ein XRD-Spektrum einer Hartstoffschicht der Art Al-Cr-Si-O-N.

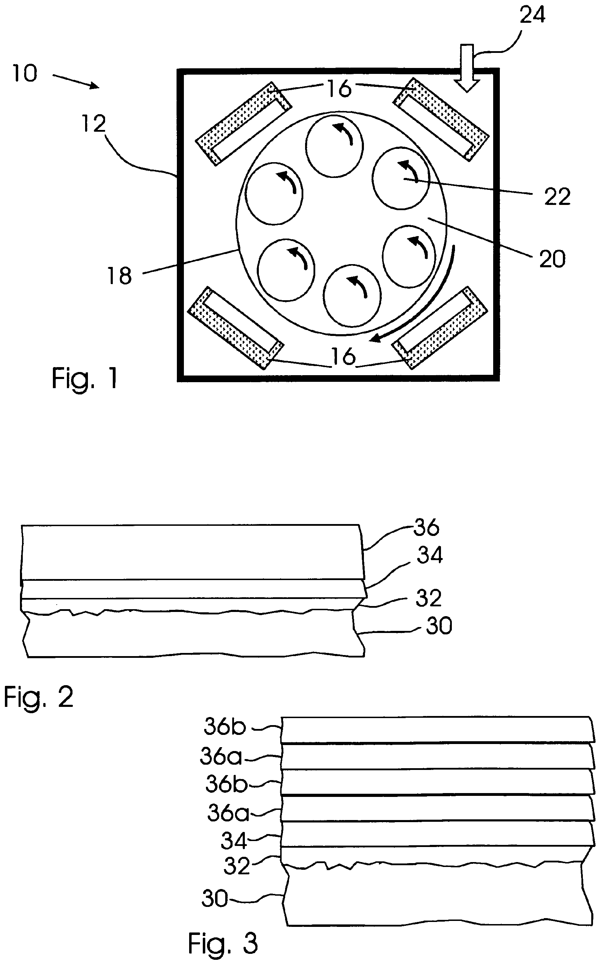

Fig.1 zeigt in symbolischer Darstellung ein Beispiel von Bestandteilen einer PVD-Beschichtungsanlage 10 zur Durchführung von Magnetron-Sputterverfahren. Derartige Anlagen sowie die Arbeitsweise zum Aufbringen von Beschichtungen sind dem Fachmann per se bekannt, so dass hier nur eine kurze eine generelle Erläuterung der Anlage 10 erfolgen soll. Auf die speziellen Betriebsarten zur Erzeugung von erfindungsgemäßen Schichten soll später eingegangen werden.

In einer Beschichtungskammer 12 unter niedrigem Druck sind eine Anzahl von, im dargestellten Beispiel vier Kathoden 16 sowie ein Substrat-Halter 18 (bestehend aus einem rotierenden Substrattisch 20 mit einer Anzahl von ihrerseits drehenden Halte-Aufbauten 22) angeordnet. Über einen Gaseinlass 24 werden die Prozessgase, bestehend aus einen Inertgas, bspw. Argon, und Reaktivgasen bspw. N2, O2 zugeleitet.

Die Kathoden 16 sind als Magnetron-Kathoden ausgebildet und weisen jeweils Targets auf, die als Platten aus dem zu zerstäubendem Material ausgebildet sind. Für das System Al-Cr-Si kann beispielsweise das Cr oder Si in Form von Stopfen in Bohrungen einer Aluminiumplatte eingesetzt werden und/oder Verbund- oder Legierungstargets aus den Materialien verwendet werden. Sind wie dargestellt mehrere Magnetrontargets vorhanden, dann kann beispielsweise jedes Magnetron eine Komponente zerstäuben und die Konzentrationen lassen sich so über die elektrische Leistung, die den Magnetrons zugeführt wird, besonders gut einstellen.

Wie dem Fachmann bekannt ist, entspricht die Zusammensetzung der Schicht beim Magnetronzerstäuben in etwa der Zusammensetzung der Targets, wenn diese zuvor eingefahren wurden. Auf der Targetseite ist dabei die Zusammensetzung im Bereich des durch die Magnetfelder des Magnetrons erzeugten Erosionsgrabens ausschlaggebend.

Im Betrieb der Anlage 10 liegt eine Spannung von beispielsweise etwa 500 Volt an den Kathoden 16 an. Zur Vermeidung von Aufladungen bei hohem Sauerstoffgehalt können die Kathoden 16 einzeln oder gegeneinander gepulst werden. Ionen des Arbeitsgases werden wechselweise zwischen jeweils zwei Targets beschleunigt und zerstäuben diese. Zusätzlich wird als reaktives Gas gasförmiger Sauerstoff oder Stickstoff durch den Gaseinlass zugeführt. Unter dem Einfluss der elektrischen und magnetischen Felder im Bereich vor den Kathoden 16 kommt es zur Ausbildung einer Beschichtungsatmosphäre in Form eines Plasmas. Die Beschichtungsatmosphäre enthält die zugeführten gasförmigen Bestandteile sowie die zerstäubten Bestandteile der Targets.

Alternativ kann die Beschichtungsanlage auch zur Ausführung des HIPIMS-Beschichtungsverfahrens ausgebildet sein. Dabei werden die Targets mit kurzzeitigen Pulsen hoher Leistung, allerdings bei niedrigem Tastverhältnis betrieben. Die Grundlagen des HIPIMS finden sich u.a. bei Kouznetsov, et al., "A Novel Pulsed Magnetron Sputter Technique Utilizing Very High Target Power Densities" in Surface and Coatings Technology, 1999, pp. 290-293, vol. 122. Die Beschichtungsanlage verfügt in diesem Fall über spezielle, für HIPIMS geeignete Leistungsversorgungen, wie bspw. beschrieben in US-A-6296742. Zusätzlich können, wie beschrieben in EP-A-1609882, verschiedene Möglichkeiten genutzt werden, die Ionen nach dem Puls auf die Substrate zu lenken.

Die jeweilige Zusammensetzung der Beschichtungsatmosphäre ist hierbei von den Zerstäubungsraten der Targetmaterialien sowie vom eingestellten Gasfluss abhängig. Sie kann beeinflusst werden durch geeignete Wahl des Materials der Targets (freie Oberfläche der jeweiligen Targetmaterialien unter Berücksichtigung der Zerstäubungsrate), aber auch durch unterschiedliche Zugabe gasförmiger Bestandteile. Beispielsweise ist bekannt, dass sich bei Sauerstoffzufluss eine sog. "Vergiftung" (d. h. Bildung eines Oxids bereits auf dem festen Targetmaterial) eines Targets aus Al ergibt. Da die Zerstäubungsrate auch vom Grad der Vergiftung abhängt (bei vergifteten Targets kommt es zu einem dramatischen Rückgang der Sputterrate) kann so durch Einstellung des Zuflusses eines gasförmigen Bestandteils (hier: O2) auch der Al-Anteil der Beschichtungsatmosphäre gezielt eingestellt werden.

Die Elemente der Beschichtungsatmosphäre lagern sich auf den Substraten, d. h. auf am Substrat-Halter 18 angebrachten Werkstücken wie Bohrer, Wendeschneidplatten etc., ab. Hierbei wird zwischen den Substraten und dem Plasma eine Potentialdifferenz erzeugt, beispielsweise durch eine Spannungsquelle zwischen dem Substrat-Halter 18 und der Wandung der Kammer 12. Aufgrund dieser Bias-Spannung kommt es auch auf dem Substrat zu einem Bombardement mit Ionen des Arbeitsgases, was zu einer höheren Verdichtung der Schicht und zu einem höheren Energieeintrag während der Schichtbildung führt. So können sich trotz niedriger Substrattemperaturen kristalline Phasen ausbilden.

Das beschriebene Ionensputtern sowie verschiedene andere PVD-Beschichtungstechniken sind dem Fachmann grundsätzlich bekannt, so dass er in der Lage ist, mit den hier gegebenen Informationen auf einem Substrat eine Schicht aus den Elementen eines jeweils gewählten Systems abzuscheiden und dabei die Parameter des Verfahrens, beispielsweise Zusammensetzung der Beschichtungsatmosphäre, Substrattemperatur, Leistung der Kathoden, Bias-Spannung usw. so einzustellen, dass ein Schichtaufbau mit jeweils gewünschter Schichtrate und -struktur erfolgt.

Zur Erzeugung von Schichten die Ausführungsformen der Erfindung darstellen wird wie folgt vorgegangen:
Als Werkstücke werden Körper, insbesondere Werkzeug-Grundkörper verwendet, die aus dem gewählten Substratmaterial, beispielsweise Werkzeugstahl (z.B. HSS-Stahl) oder Hartmetall (bspw. WC-Co Hartmetall) bestehen. Diese werden an den Substrat-Haltern 18 angebracht. Es erfolgt dann in an sich bekannter Weise eine Vorbereitung des Substrats durch Ionenbeschuß. Hierfür wird ohne elektrische Leistung an den Targets und unter Zufuhr nur eines Edelgases (Argon) ein Plasma in der Kammer 12 erzeugt und eine hohe Bias-Spannung zwischen Plasma und den Substraten angelegt.

Im folgenden Beschichtungsschritt wird das Material der Targets zerstäubt und zusätzlich zum Edelgas auch ein Reaktivgas zugeführt, so dass die entsprechenden Materialien sich aus dem Plasma auf dem Substrat ablagern.

Zunächst wird auf dem Substrat eine Haftschicht erzeugt. Hierbei können die Targets wie beschrieben jeweils paarweise wechselseitig elektrisch gepulst werden. Als Reaktivgas wird Stickstoff mit zugeführt, so dass sich auf dem Substart eine Schicht ablagert. In einem bevorzugten Beispiel ist dies eine (Al, Cr, Si)-N Schicht.

Sobald die gewünschte Schichtdicke der Haftschicht erreicht ist beginnt eine Übergangsphase, in der auf die Haftschicht eine Übergangsschicht aufgebracht wird. Hierfür wird bei unveränderter Ansteuerung der Targets die Zusammensetzung des Prozessgases so verändert, dass über die Dauer der Übergangsphase der StickstoffAnteil zugunsten eines Sauerstoff-Anteils kontinuierlich abgesenkt wird. Zum Ende der Übergangsphase erfolgt entweder zur Erzeugung reiner Oxid-Schichten keine weitere Stickstoff-Zufuhr mehr, oder die Stickstoffzufuhr wird auf einem niedrigen Niveau beibehalten.

Danach wird das Verfahren mit dem Aufbringen einer Al-Cr-Si-Oxidschicht (ggfs. auch - in geringem Anteil - als Nitridschicht) fortgesetzt. Hier wird ausschließlich oder wenigstens überwiegend Sauerstoff als Reaktivgas zugeführt. Nach Erreichen der gewünschten Schichtdicke wird der Prozeß beendet.

Fig. 2 zeigt schematisch den entstandenen Schichtaufbau. Auf dem Substrat 30 befindet sich eine Haftschicht 32, deren Zusammensetzung abhängt von den während ihrer Aufbringung im Plasma befindlichen Elementen (d.h. Reaktivgas und zerstäubte Targets). Die Dicke der Haftschicht hängt von der gewählten Beschichtungsdauer mit den entsprechenden Bedingungen ab. Auf der Haftschicht folgt eine gradierte Übergangsschicht 34, bei der Dicke und Zusammensetzung wie oben beschrieben gewählt werden können. An die Übergangsschicht schließt sich die Hartstoffschicht 36 an.

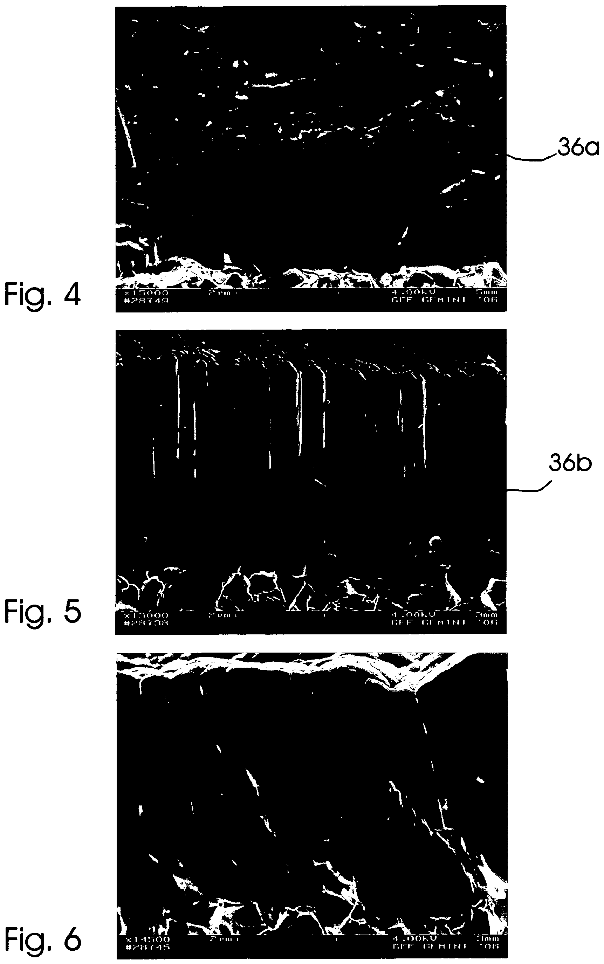

Fig.4 und 5 zeigen Fotos von Schliffen beschichteter Körper mit (Al,Cr,Si)2O3-Hartstoffschichten 36a, 36b, die unter gleichen Bedingungen auf der gleichen Haftschicht abgeschieden wurden. Lediglich die Zusammensetzung der Targets war verändert. Die Hartstoffschichten enthalten einige Atomprozente Si und zeigen eine kristalline Mikrostruktur.

Fig.4 zeigt eine Cr-arme Schicht 36a mit einer kubischen Phase der Raumgruppe Fd3m.

Fig.5 zeigt eine Cr-reiche Hartstoffschicht 36b mit einer hexagonalen Phase der Raumgruppe R-3c. Die Hartstoffschicht hat eine stengelige, kristalline Mikrostruktur.

Fig.6 zeigt zur Veranschaulichung ein Vergleichsbeispiel mit einer reinen Al2O3-Hartstoffschicht auf einer (Al,Cr,Si)N Haftschicht. Die Al2O3-Schicht hat ein amorphes Aussehen.

Die Hartstoffschicht 36 in Fig. 2 wurde durch konstante Bedingungen während der Beschichtungsdauer erzeugt. Alternativ kann auch eine Multilayer-Struktur erzeugt werden, wenn sich die Bedingungen am Substrat während der Beschichtungsdauer ändern. Fig. 3 zeigt schematisch einen solchen Multilayer-Schichtaufbau. Auf dem Substrat 30 befindet sich auch hier eine Haftschicht 32 und eine Übergangsschicht 34. Die Beschichtung darüber umfaßt abwechselnd Schichten 36a und 36b (im gezeigten Beispiel je zwei, selbstverständlich können allerdings beliebige Anzahlen erzeugt werden). Die Schichten 36a und 36b unterscheiden sich durch unterschiedliche Zusammensetzung. Diese können erzielt werden indem bspw. während der Beschichtungsdauer unterschiedliche Prozessgase zugeführt werden (bspw. wechselweise Stickstoff/Sauerstoff) oder durch unterschiedliche Target-Bestückung.

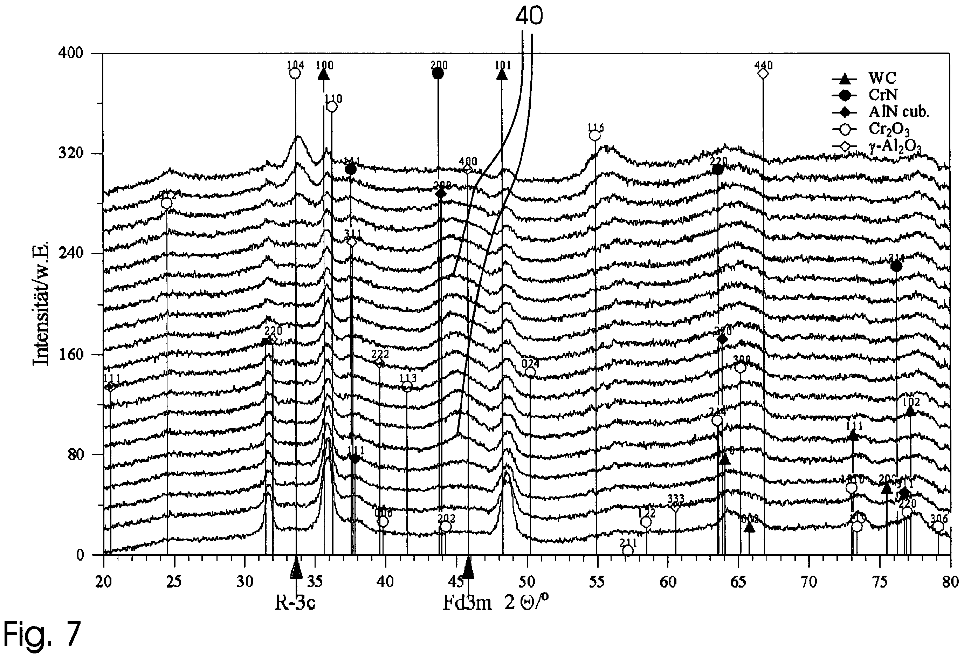

Die Struktur der erzielten Hartstoffschicht hängt von der Zusammensetzung ab. Fig.7 zeigt XRD-Spektren von Hartstoffschichten der Art Al-Cr-Si-O. Diese Schichten wurden auf einer Al-Cr-Si-N Zwischenschicht auf einem WC-Co-Hartmetal abgeschieden. Die Prozessbedingungen waren bis auf die Zusammensetzung der Targets gleich.

In Fig.7 beträgt der atomare Anteil von Si unter den Metallen ca. 5 Atomprozent und der Cr-Anteil steigt von unten nach oben von ca. 20 At.% auf 70 At.%. Der Rest ist Aluminium. Bei einem Winkel 2-theta von knapp 46° ist die Lage des (400)-gamma-Al2O3 Peaks als Linie gekennzeichnet. Mit steigendem Cr-Gehalt bildet sich ab einem bestimmten Cr-Gehalt links davon ein Peak 40 aus, der sich mit steigendem Cr-Gehalt, weiter nach links bewegt, was die zunehmende Substitution von Al durch Cr im (Al,Cr,Si)2O3-Kristall anzeigt. Steigt der Chromgehalt noch weiter, nimmt der zugehörige Peak ab und es findet sich zunehmend der Peak einer hexagonalen Phase mit der Raumgruppe R-3c bei einem 2-theta-Winkel von knapp 34°.

Diese Peaks finden sich nur in einem bestimmten Konzentrationsbereich der Elemente. Die Prozentangaben in Atomprozent (At.%) sind die relativen Anteile der metallischen Elemente Al, Cr und Si untereinander. Andere metallische Elemente waren hier in den Schichten nicht enthalten. Im XRD Spektrum sind ferner Phasen der Zwischenschicht sowie Phasen mit Wolfram zu erkennen. Letztere sind durch das Hartmetallsubstrat bedingt.

Im Folgenden werden konkrete Beispiele von Ausführungsformen der Erfindung angegeben:

### Beispiel 1 Al-Cr-Si-Oxidschicht

Auf einem Hartmetal-Werkzeug soll eine Al-Cr-Si-Oxid-Schicht mit einer Al-Cr-Si-Nitrid Haftschicht und einer Al-Cr-Si-Oxinitrid-Übergangsschicht im PVD-Verfahren abgeschieden werden.

In einer Anlage des Typs CC800 der Anmelderin befinden sich vier Targets aus Platten einer Al-Si Legierung mit 10 At.% Silizium, in die Cr-Stopfen eingelassen sind. Der flächenmäßige Cr-Anteil im Erosionsgraben beträgt ca. 33 %. Alle verwendeten Targets wurden vor den Versuchen eingefahren.

Zu Beginn des Prozesses werden die Substrate auf ca. 400°C aufgeheizt. Nach dem üblichen Plasmaätzen der Substrate durch Beschuss mit Argonionen wird zusätzlich zum Argon Stickstoffgas eingelassen. Die Kathoden werden bipolar zwischen jeweils zwei Kathoden bei einer Frequenz von 250 kHz im Pulsbetrieb betrieben.

Es wird eine Leistung von 5 kW für jede der vier Kathoden, d. h. insgesamt 20 kW eingestellt. Es stellt sich eine Substrattemperatur von 520°C ein, bei der kristalline Al-Cr-Si-Nitrid Schichten abgeschieden werden. Aus den eingestellten Parametern resultiert eine Schichtrate von etwa 1,5 µm/h. Nach wenigen Minuten wird das Stickstoffgas über wenige Minuten hinweg langsam auf Null zurückgefahren während gleichzeitig das Sauerstoffgas auf seinen Sollwert hochgefahren wird.

Die Schichtdicke beträgt nach 2,5 Stunden ca. 3,5 µm. Die Größe der Körner der Schicht beträgt etwa 50-100 nm. Die Härte der hergestellten Schicht beträgt ca. 2400 HV. Im XRD-Spektrum zeigt sich u.a. die gamma-Phase eines (Al,Cr)2O3 bzw. (Al,Cr,Si)2O3 Substitutionsmischkristalls.

### Vergleichbeispiel 1

Es werden im wesentlichen die gleichen Parameter eingestellt, wie in Beispiel 1 allerdings beinhalten die Targets kein Silizium mehr sondern bestehen aus reinem Aluminium mit Cr-Stopfen. Die Parameter wurden hinsichtlich der geänderten Targets geringfügig angepasst. Die Beschichtungszeit wurde so gewählt, dass sich die gleiche Schichtdicke wie in Beispiel 1 ergab.

Die Härte der hergestellten Schicht beträgt ca. 2200 HV. Bei einem manuell durchgeführten Abrasionstest kommt es im Gegensatz zu Beispiel 1 zu einem Versagen der Kanten, da sich die Schicht partiell löst. Im XRD zeigen sich keine Phasen aus dem System Al-Cr-O.

### Vergleichbeispiel 2

Es werden im wesentlichen die gleichen Parameter eingestellt wie in Beispiel 1, allerdings bestehen die Targets nur noch aus Aluminium. Die Parameter wurden hinsichtlich der geänderten Targets geringfügig angepasst. Die Beschichtungszeit wurde so gewählt, dass sich die gleiche Schichtdicke wie in Beispiel 1 ergab. Die Härte betrug nur noch 1200 HV. Kristalline Phasen des Al2O3 waren nicht oder höchstens andeutungsweise zu finden.

### Beispiel 2

Es werden die gleichen Parameter wie in Beispiel 1 eingestellt. Zwei der Targets weisen allerdings einen um die Hälfte geringeren Si-Gehalt auf. Durch die Drehung des Substrattisches vor den Target entsteht ein Multilayersystem mit kontinuierlich wechselndem Si-Gehalt und in Folge mit wechselnder Zusammensetzung der (Al,Cr,Si)2O3 Phase. Im Vergleich zu Beispiel 1 zeigt sich eine bessere Haftung beim Rockwelltest.

### Beispiel 3

Es werden im wesentlichen die gleichen Parameter wie in Beispiel 1 eingestellt. Zwei der vier Targets bestehen allerdings jeweils aus einer Titanplatte mit Aluminiumstopfen. Da jeweils nur zwei der vier Targets laufen, muss die Beschichtungszeit entsprechend verlängert werden. Zunächst werden nur die beiden TiAl-Targets mit Stickstoff als Reaktivgas betrieben bis eine ca. 2 µm dicke TiAlN-Schicht entstanden ist.

Anschließend werden die Magnetrone mit den TiAl-Targets aus- und die mit AlCrSi-Targets eingeschaltet. Unmittelbar anschließend wird der Zufluss von Stickstoff unterbunden und gleichzeitig Sauerstoff eingelassen. Es bildet sich eine ca. 100 nm dicke Übergangsschicht aus AlCrSiNO, auf die dann eine AlCrSiO Schicht wie in Beispiel 1 aufwächst. Bei einer Gesamtschichtdicke von ebenfalls 3,5 µm wurde der Prozess gestoppt: Im Rahmen des Messgenauigkeit weist die Schicht gleich gute Eigenschaften, wie die Schicht in Beispiel 1 auf.

### Beispiel 4

In einem weiteren Beispiel erfolgt eine Beschichtung des Substrats mit einer Hartstoffschicht aus CrAlSiO(N) durch gepulstes DC-Magnetronsputtern.

Die Beschichtung wird mittels zweier Targets mit einer Zusammensetzung im Verhältnis Al:Cr:Si von 60:35:5 At% abgeschieden. Zunächst wird eine CrAlSiN-Schicht von 1,7 µm Dicke unter folgenden Bedingungen aufgebracht. Targetleistung 3100 W, Targetspannung 310 V, Totaldruck 500 mPa, N2-Fluss 135 ml/min, Ar-Fluss 400 ml/min und Substrattemperatur 300°C.

Dann wird eine 0,2µm dicke Übergangsschicht durch eine Abnahme des N2-Flusses auf 60 ml bei gleichzeitige Zunahme des O2-Flusses von 0 ml auf 17 ml erzeugt.

Darauf wird eine Hartstoffschicht mit einer Dicke von 2,9 µm unter folgenden Bedingungen aufgebracht: Targetleistung 3100 W, Targetspannung 350 V, Totaldruck 255 mPa, N2 Fluss 60 ml/min, Ar-Fluss 240 ml/min, O2 Fluss 17 ml, Substrattemperatur 300°C. Da Stickstoff weniger reaktiv ist muss relativ mehr Stickstoff zugegeben werden.

Der Stickstoffanteil in der Hartstoffschicht beträgt 45 At.%. Bei den Metallanteilen ergeben sich die Atomverhältnisse von Al:Cr:Si zu 57:37:6.

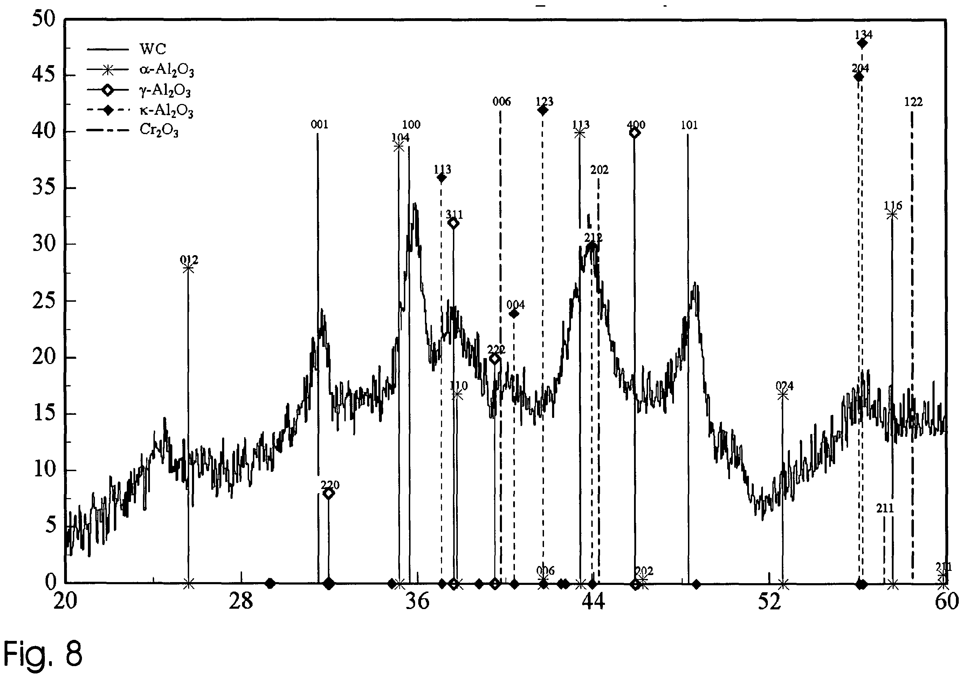

In Fig. 8 ist ein XRD-Spektrum der erzeugten Hartstoffschicht gezeigt. Das zugehörige XRD-Spektrum zeigt Peaks von kristallinem Cr2O3 sowie von gamma- und kappa-Al2O3. Das vorhandenen Si zeigt keine eigenen kristallinen Phasen, sondern liegt an den Korngrenzen als amorphes Si oder als amorphe Si-Verbindung, bspw. als Si3N4 vor. Andere Peaks rühren vom Hartmetallsubstart (WC) her.

Die Härte der Schicht beträgt 2800 HV.

### Beispiel 5

In einem weiteren Beispiel wird eine Schichtfolge wie in Beispiel 4 mittels HiPiMS hergestellt, wobei die zeitlich gemittelte elektrische Leistung an den Targets gleich dem Beispiel 4 gewählt wird. Während des Pulses beträgt die mittlere Spannung 650 V und die maximale Leistungsdichte vor dem Target 4 kW/cm². Die Härte beträgt 3100 HV.

## Patentansprüche

1. Schneidwerkzeug zum Zerspanen, mit
- einem Substrat
- und einer auf dem Substrat aufgebrachten Hartstoffschicht, die mittels Magnetronzerstäubens abgeschieden ist und das Schneidwerkzeug mindestens teilweise bedeckt
**dadurch gekennzeichnet, dass**
- die Hartstoffschicht die metallischen Elemente Al, Cr und Si sowie nichtmetallische Elemente ausgewählt aus der Gruppe B, C, N, O enthält,
- wobei der atomare Anteil von Sauerstoff an den nichtmetallischen Elementen größer als 30% ist.

2. Schneidwerkzeug nach Anspruch 1, **dadurch gekennzeichnet, dass**
- der atomare Anteil von Sauerstoff an den nichtmetallischen Elementen größer als 70% ist.

3. Schneidwerkzeug nach Anspruch 2, **dadurch gekennzeichnet, dass**
- der atomare Anteil von Sauerstoff an den nichtmetallischen Elementen nahezu 100% beträgt.

4. Schneidwerkzeug nach einem der vorhergehenden Ansprüche, **dadurch gekennzeichnet, dass**
- die metallischen Elemente Al, Cr und Si in der Hartstoffschicht eine Zusammensetzung der Form Al x Cr y Si z aufweisen, wobei x, y und z die Anteile der drei Elemente untereinander in Atomprozent angeben
- und x, y, z den Bedingungen genügen
- x =100% - y - z,
- 1% <=y <= 70% und
- 0,1% <= z <= 20%.

5. Schneidwerkzeug nach einem der vorhergehenden Ansprüche, **dadurch gekennzeichnet, dass**
- in der Hartstoffschicht der atomare Anteil der metallischen Elemente aus der Gruppe Al, Cr, Si insgesamt mehr als 50 At.%, weiter bevorzugt mehr als 80 At.%, besonders bevorzugt nahezu 100 At.% ausmacht.

6. Schneidwerkzeug nach einem der vorhergehenden Ansprüche, **dadurch gekennzeichnet, dass**
- sich zwischen dem Substrat und der Hartstoffschicht eine Haftschicht befindet, die sich aus einer Auswahl von Elementen aus der Menge Al, Si und Elementen der Gruppen 4 bis 6 des Periodensystems nach IUPAC (1988), sowie aus einer Auswahl von nichtmetallischen Elementen aus der Gruppe B, C, N, O zusammensetzt.

7. Schneidwerkzeug nach Anspruch 6, **dadurch gekennzeichnet, dass**
- die metallischen Elemente der Haftschicht aus der Gruppe der metallischen Elemente der Hartstoffschicht ausgewählt sind und der atomare Anteil von N an den nichtmetallischen Elementen in der Haftschicht größer ist als in der Hartstoffschicht.

8. Schneidwerkzeug nach einem der Ansprüche 6, 7, **dadurch gekennzeichnet, dass**
- sich zwischen der Hartstoffschicht und der Haftschicht eine Übergangsschicht befindet, die sich aus einer Auswahl der Elemente zusammensetzt, die die Hartstoff- und Haftschicht bilden.

9. Schneidwerkzeug nach Anspruch 8, **dadurch gekennzeichnet, dass**
- in der Übergangsschicht in der Richtung quer zur Schicht sich wenigstens ein Element in seiner Konzentration kontinuierlich ändert, so dass die Konzentration des Elements an der Grenze zur Hartstoffschicht im wesentlichen gleich der Konzentration in der Hartstoffschicht ist und an der Grenze zur Haftschicht im wesentlichen gleich der Konzentration in der Haftschicht ist.

10. Schneidwerkzeug nach einem der Ansprüche 6-9, **dadurch gekennzeichnet, dass**
- die Hartstoffschicht im Wesentlichen aus Al, Cr, Si und O besteht und die Haftschicht aus Al, Cr, Si und N.

11. Schneidwerkzeug nach einem der Ansprüche 6-10 **dadurch gekennzeichnet, dass**
- die Haftschicht aus (Al,Cr,Si)N besteht.

12. Schneidwerkzeug nach einem der vorhergehenden Ansprüche, **dadurch gekennzeichnet, dass**
- die Hartstoffschicht die äußerste Schicht ist oder die letzte Schicht vor einer ggf. aufgebrachten Farb-, Gleit- oder Trockenschmierstoffschicht.

13. Schneidwerkzeug nach einem der vorhergehenden Ansprüche, **dadurch gekennzeichnet, dass**
- das Schneidwerkzeug eine Mehrlagenbeschichtung aufweist, die aus einer Folge von Haft-, Übergangs- und Hartstoffschichten besteht.

14. Schneidwerkzeug nach einem der vorangehenden Ansprüche, **dadurch gekennzeichnet, dass** in der Hartstoffschicht
- der Anteil von Stickstoff an den Nichtmetallen im Bereich von 10 At. % - 70 At.% liegt.

15. Verfahren zur Herstellung einer Hartstoffschicht auf einem Substrat, bei dem
- mittels Magnetronzerstäubens mit Sauerstoff als Reaktivgas eine Hartstoffschicht auf dem Substrat abgeschieden wird,
- wobei die Hartstoffschicht die metallischen Elemente Al, Cr und Si sowie nicht-metallische Elemente ausgewählt aus der Gruppe B, C, N, O enthält,
- wobei der atomare Anteil von Sauerstoff an den nichtmetallischen Elementen größer als 30% ist.

16. Verfahren nach Anspruch 15, bei dem
- die Hartstoffschicht durch hochleistungsgepulstes Magnetronzerstäuben abgeschieden wird.

## Claims

1. A cutting tool for machining, comprising
- a substrate,
- and a hard material layer applied to the substrate, said layer being deposited by means of magnetron sputtering and covering at least partially the cutting tool
**characterized in that**
- the hard material layer comprises the metallic elements Al, Cr and Si and non-metallic elements selected from the group comprising B, C, N, O,
- wherein the atomic proportion of oxygen in the non-metallic elements is greater than 30%.

2. The cutting tool according to claim 1, **characterized in that**
- the atomic proportion of oxygen in the non-metallic elements is greater than 70%.

3. The cutting tool according to claim 2, **characterized in that**
- the atomic proportion of oxygen in the non-metallic elements is almost 100%.

4. The cutting tool according to one of the preceding claims, **characterized in that**
- the metallic elements Al, Cr and Si in the hard material layer have a composition of the Al x Cr y Si z type, wherein x, y and z are the percentages of the three elements in atom % amongst each other,
- and x, y, z satisfy the conditions:
- x = 100% - y - z,
- 1% ≤ y ≤ 70% and
- 0.1% ≤ z ≤ 20%.

5. The cutting tool according to one of the preceding claims, **characterized in that**
- in the hard material layer, the atomic proportion of the metallic elements from the group comprising Al, Cr, Si is overall more than 50 atom %, further preferably more than 80 atom %, particularly preferably almost 100 atom %.

6. The cutting tool according to one of the preceding claims, **characterized in that**
- between the substrate and the hard material layer there is an adhesion layer composed of a selection of elements from the volume Al, Si and elements of the groups 4 - 6 of the period system according to IUPAC (1988), and of a selection of non-metallic elements from the group comprising B, C, N, O.

7. The cutting tool according to claim 6, **characterized in that**
- the metallic elements of the adhesion layer are selected from the group of metallic elements of the hard material layer and the atomic proportion of N in the non-metallic elements in the adhesion layer is greater than in the hard material layer.

8. The cutting tool according to one of the claims 6, 7, **characterized in that**
- between the hard material layer and the adhesion layer there is a transition layer comprised of a selection of the elements which form the hard material and adhesion layers.

9. The cutting tool according to claim 8, **characterized in that**
- at least one element continuously varies in its concentration in the transition layer in the direction transverse to the layer so that the concentration of the element at the boundary to the hard material layer is essentially equal to the concentration in the hard material layer and at the boundary to the adhesion layer is essentially equal to the concentration in the adhesion layer.

10. The cutting tool according to one of the claims 6 - 9, **characterized in that**
- the hard material layer is comprised essentially of Al, Cr, Si and O and the adhesion layer of Al, Cr, Si and N.

11. The cutting tool according to one of the claims 6 - 10, **characterized in that**
- the adhesion layer is of (AI,Cr,Si)N.

12. The cutting tool according to one of the preceding claims, **characterized in that**
- the hard material layer is the outermost layer or the last layer before a paint, lubricant or dry lubricant layer, if any, is applied.

13. The cutting tool according to one of the preceding claims, **characterized in that**
- the cutting tool has a multi-layer coating comprised of a succession of adhesion, transition and hard material layers.

14. The cutting tool according to one of the preceding claims, **characterized in that**, in the hard material layer
- the proportion of nitrogen in the non-metals is in the range of 10 atom % - 70 atom %.

15. A method for manufacturing a hard material layer on a substrate, wherein
- a hard material layer is deposited on the substrate by means of magnetron sputtering with oxygen as reactive gas,
- wherein the hard material layer comprises the metallic elements Al, Cr and Si and non-metallic elements selected from the group comprising B, C, N, O,
- wherein the atomic proportion of oxygen in the non-metallic elements is greater than 30%.

16. The method according to claim 15, wherein
- the hard material layer is deposited by high power pulsed magnetron sputtering.

## Revendications

1. Outil de coupe pour l'usinage, comprenant
- un substrat
- et une couche de matière dure appliquée sur le substrat, déposée par pulvérisation à magnétron et recouvrant au moins partiellement l'outil de coupe,
**caractérisé en ce que**
- la couche de matière dure contient les éléments métalliques Al, Cr et Si, ainsi que des éléments non métalliques sélectionnés parmi le groupe B, C, N, O,
- dans laquelle la part atomique d'oxygène dans les éléments non métalliques est supérieure à 30%.

2. Outil de coupe selon la revendication 1, **caractérisé en ce que**
- la part atomique d'oxygène dans les éléments non métalliques est supérieure à 70%.

3. Outil de coupe selon la revendication 2, **caractérisé en ce que**
- la part atomique d'oxygène dans les éléments non métalliques s'élève quasiment à 100%.

4. Outil de coupe selon l'une des revendications précédentes, **caractérisé en ce que**
- les éléments métalliques Al, Cr et Si présentent une composition de la forme Al x Cr y Si z dans la couche de matière dure, où x, y et z indiquent les parts des trois éléments entre eux dans le pourcentage atomique,
- et x, y, z satisfont aux conditions
- x = 100% - y - z,
- 1 % <= y <= 70% et
- 0,1% <= z <= 20%.

5. Outil de coupe selon l'une des revendications précédentes, **caractérisé en ce que**
- dans la couche de matière dure, la part atomique des éléments métalliques issus du groupe Al, Cr, Si représentent au total plus de 50% en atome, de préférence plus de 80% en atome, de manière particulièrement préférentielle quasiment 100% en atome.

6. Outil de coupe selon l'une des revendications précédentes, **caractérisé en ce que**
- une couche adhésive se trouve entre le substrat et la couche de matière dure, laquelle est composée d'une sélection d'éléments issus du volume Al, Si et des éléments du groupe 4 à 6 du tableau périodique selon IUPAC (1988), ainsi que d'une sélection d'éléments non métalliques issus du groupe B, C, N, O.

7. Outil de coupe selon la revendication 6, **caractérisé en ce que**
- les éléments métalliques de la couche adhésive sont sélectionnés parmi le groupe des éléments métalliques de la couche de matière dure et la part atomique de N dans les éléments non métalliques dans la couche adhésive est plus élevée que dans la couche de matière dure.

8. Outil de coupe selon l'une des revendications 6, 7, **caractérisé en ce que**
- une couche de transition se trouve entre la couche de matière dure et la couche adhésive, laquelle est composée d'une sélection des éléments formant la couche de matière dure et la couche adhésive.

9. Outil de coupe selon la revendication 8, **caractérisé en ce que**
- dans la couche de transition, dans la direction transversale à la couche, au moins un élément varie continuellement dans sa concentration, de telle façon que la concentration de l'élément à la limite de la couche de matière dure est essentiellement identique à la concentration dans la couche de matière dure, et essentiellement identique à la concentration dans la couche adhésive à la limite de la couche adhésive.

10. Outil de coupe selon l'une des revendications 6-9, **caractérisé en ce que**
- la couche de matière dure est constituée essentiellement d'Al, Cr, Si et O et la couche adhésive est constituée d'Al, Cr, Si et N.

11. Outil de coupe selon l'une des revendications 6-10, **caractérisé en ce que**
- la couche adhésive est constituée de (Al, Cr, Si)N.

12. Outil de coupe selon l'une des revendications précédentes, **caractérisé en ce que**
- la couche de matière dure est la couche située le plus à l'extérieur ou la dernière couche avant une couche de colorant, d'agent de glissement ou de lubrifiant sec, appliquée le cas échéant.

13. Outil de coupe selon l'une des revendications précédentes, **caractérisé en ce que**
- l'outil de coupe présente un revêtement à plusieurs couches, lequel est constitué d'une série de couches adhésive, de transition et de matière dure.

14. Outil de coupe selon l'une des revendications précédentes, **caractérisé en ce que** dans la couche de matière dure
- la part d'azote dans les éléments non métalliques varie entre 10% en atome et 70% en atome.

15. Procédé pour la fabrication d'une couche de matière dure sur un substrat, dans lequel
- une couche de matière dure est déposée sur le substrat par pulvérisation à magnétron avec de l'oxygène comme gaz réactif,
- dans lequel la couche de matière dure contient les éléments métalliques Al, Cr et Si ainsi que des éléments non métalliques sélectionnés parmi le groupe B, C, N, O,
- dans lequel la part atomique d'oxygène dans les éléments non métalliques est supérieure à 30%.

16. Procédé selon la revendication 15, dans lequel
- la couche de matière dure est déposée par pulvérisation à magnétron à impulsions haute puissance.
